# EUROPEAN PATENT APPLICATION

(11) **EP 1 309 050 A1**
(43) Date of publication of application: **07.05.2003**
(21) Application number: 01309411.5
(22) Date of filing: 06.11.2001
(51) Int. Cl.: H01S 5/10, H01S 5/0625

(54) **Laser device and method therefor**

(71) Applicant: Agilent Technologies, Inc. (a Delaware corporation), Palo Alto, CA 94303 (US)
(72) Inventor: Plumb, Richard Gordon, Ipswich, Suffolk IP8 3QQ (GB)
(74) Representative: Coker, David Graeme

(57) **Abstract**

One type of known tunable laser device comprises a waveguide region in which a number of damage sites are introduced. However, such devices are time consuming to produce and so cost ineffective from a manufacturing perspective. The invention provides a laser device (100) having a waveguide region (210, 212, 214). The waveguide region (210, 212, 214) comprises a longitudinal layer having a surface. The surface of the layer is stepped.

## Description

The present invention relates to a laser device, for example, of the type capable of being tuned so as to controllably generate different wavelengths. The present invention also relates to a method of manufacturing the laser device.

For about 15 years, there has been a need for tunable lasers in the field of optical communications. A tunable laser is capable of selectively generating light of a specific wavelength from a number of wavelengths and is useful to achieve wavelength routing as well as re-use of empty wavelength slots in a complex Wavelength Division Multiplexed (WDM) system. Such uses assist in making a most efficient use of optical fibre bandwidth, which is not infinite, thereby increasing flexibility of an optical communications system.

A central problem to producing a tunable laser is the ability to find a tuning mechanism capable of covering a sufficient range of wavelengths. Additionally, the tunable laser must emit electromagnetic radiation, such as light in the visible range of the electromagnetic spectrum, in a single mode. There are many types of tunable laser that have been postulated, and often demonstrated as laboratory samples. A review of examples of such devices can be found at Chapter 8 of "DFB semiconductor lasers" by Carroll, Whiteaway and Plumb (IEE, London 1997). Other types of non-grating tunable lasers include tunable Vertical Cavity Surface Emitting Lasers (VCSELs), "Y" lasers, and Cleared Coupled Cavity (C³) lasers.

VCSELs employ very short cavities which generate a widely spaced Fabry-Perot comb, the gain spectrum of the material thereby only exciting one *longitudinal* mode. However, although such devices generate a single longitudinal mode, they often generate multiple *transverse* modes. Also, VCSELs have a small cavity volume resulting in low optical output power. The physics associated with the VCSEL structure means that VCSELs operate well at 980nm and below, but at longer wavelengths such lasers struggle to work at all (by direct electrical pumping, at least). In addition, the tuning structures proposed thus far for VCSELs employ mechanical movement of nano structures which are exposed to the ambient atmosphere of a package and so are inherently vulnerable to dirt and damage; mechanical engineers suggest that hysteresis and creep are therefore difficult to avoid.

Y-lasers are essentially interferometric devices comprising two, otherwise conventional, edge emitting Fabry-Perot lasers joined by a Y coupler known in the art. Each of the two lasers has a respective Fabry-Perot single mode, on different respective combs. One branch of the Y coupler is longer than the other branch thereof. The Y laser hence operates at wavelengths where modes in the two combs coincide. Tuning is achieved by splitting contacts to the two branches, and independently controlling the drive currents so that the carrier densities in the two branches (and hence their refractive indices) change. The carrier densities are constrained by lasing action and clamping the round trip gain to unity. Such structures are, however, very current critical, and sidemode suppression is dubious. A more effective solution employs a third branch, thereby employing *three* separate lasing paths, all of which have to provide identical wavelengths from their respective combs. Spurious modes are reduced and the tuning range increased making this "Y³" device effective, but since two Y couplers are required as well as at least four separate drive currents, such devices are difficult to construct, operate and are lossy. There are also four separate laser waveguide ends at facets, so efficiency into a single fibre is poor.

A C³ laser is a simple Fabry-Perot laser, mounted active-side up on a flexible submount, and then scribed and cleaved to produce a cleaved gap. The laser thus becomes two quasi independent lasers, coupled via a short air gap. Each quasi independent laser has its own Fabry-Perot comb, and the compound device lases when two comb lines coincide. Under optimum conditions such lasers show a very good single mode and tuning behaviour. However, the cleaved gap and associated air interface results in the properties of the laser changing radically if the cleared gap length changes by as little as 1/20^{th} of a wavelength. Additionally, losses occur due to slight misalignment of the two quasi independent lasers. Consequently, although C³ lasers may be tunable and single mode, it is extremely difficult to manufacture two which exhibit the same behaviour, and many do not exhibit the stability required for optical communications. The cleaved gap is also very vulnerable to dirt and changes with time and temperature.

Another type of laser structure comprises a conventional Fabry-Perot structure. Damage sites are introduced, by focused ion beam etching, between end facets of the laser structure. The damage sites can be shallow cuts in an active stripe of the Fabry-Perot structure, the cut extending to side edges of the laser structure. Devices formed according to this structure are known and modelled results have been presented at the conference on Semiconductor and Integrated Opto-Electronics (SIOE), Cardiff, 1998. Such devices exhibit quasi continuous tuning over about 15nm and a Side Mode Suppression Ratio (SMSR) of approximately 25dB. However, since these devices are formed using ion beam etching, a number of hours are required, per laser device, to create the cuts, the ion beam etcher being a very expensive piece of machinery. Therefore, commercial manufacture of such laser is currently not a viable proposition.

According to a first aspect of the present invention, there is provided a laser device comprising a Fabry-Perot structure including a waveguide region, wherein the waveguide region comprises a longitudinal layer having a surface, characterised in that the surface of the layer is stepped.

Preferably, the waveguide region comprises a first sub-region and a second sub-region, the first and second sub-regions being substantially independently controllable with respect to each other.

Preferably, the first sub-region comprises a first waveguide layer and the second sub-region comprises a second waveguide layer, the first waveguide layer having a first optical length associated therewith and the second waveguide layer having a second optical length associated therewith, the first and second optical lengths being substantially independently adjustable with respect to each other.

The waveguide region may comprise a first sub-region having a first optical length associated therewith and a second sub-region having a second optical length associated therewith, the first and second optical lengths being substantially independently adjustable.

Preferably, the waveguide region is arranged to cause reflection, when in use, of electromagnetic radiation generated within the waveguide region. More preferably, the reflection is caused by the surface being stepped and the first optical length being different to the second optical length.

The stepped surface may comprise a first step located at a first longitudinal position corresponding to a first fraction of a substantially total longitudinal length of the waveguide region, and a second step located at a second longitudinal position corresponding to a second fraction of the substantially total longitudinal length of the waveguide region, the first fraction not being a multiple or sub-multiple of the second fraction.

The waveguide region of the laser device may comprise a layer having a surface, the surface being an upper, lower or side surface. The surface of the layer comprises a step. The step, by definition, can include a change in plane in which the surface lies or a notch or a recess in the surface. Hence, the surface should not lie in a single plane. The waveguide region may include a lower waveguide layer, an active layer and/or an upper waveguide layer. The active layer may be a single bulk layer or, as understood in the art, may be an active region of quantum wells.

According to a second aspect of the present invention, there is provided a tunable laser device as set forth above in accordance with the first aspect of the present invention.

According to a third aspect of the present invention, there is provided a semiconductor laser device as set forth above in accordance with the first aspect of the present invention.

According to a fourth aspect of the present invention, there is provided a method of manufacturing a laser device, the method comprising the steps of: constructing a Fabry-Perot laser structure comprising a waveguide region, the waveguide region comprising a longitudinal layer having a surface, characterised by forming the longitudinal layer so that the surface is stepped.

According to a fifth aspect of the present invention, there is provided a method of tuning a laser device, the laser device comprising a Fabry-Perot structure including a waveguide region, wherein the waveguide region comprises a longitudinal layer having a stepped surface, the waveguide region comprising a first sub-region having a first optical length associated therewith and a second sub-region having a second optical length associated therewith, the method comprising the step of: independently adjusting the first and second optical lengths so as to cause reflections of electromagnetic radiation within the waveguide region.

According to a sixth aspect of the present invention, there is provided a use of a laser device, the laser device comprising a Fabry-Perot structure including a waveguide region, the waveguide region comprising a longitudinal layer having a stepped surface, the use being characterised by the generation of electromagnetic radiation of a selectable wavelength.

For the avoidance of doubt, it should be understood that the surface of the waveguide region is intentionally stepped.

It is thus possible to provide a laser device that emits electromagnetic radiation in a single mode of adequate linewidth and sidemodes below 20dB. Such devices have a good tuning range of at least 10nm, but up to about 40nm (the entire erbium amplifier window, i.e. the range of wavelengths over which gain from erbium doped fibre amplifiers is of use - about 1490 to 1530 nm). Very importantly, the wavelengths emitted by such devices are stable, controllable and capable of generating output powers of at least 1mW. Additionally, the above properties are testable and signals generated by such devices are capable of modulation, for example, by means of a separate, or external, modulator, i.e. not monolithically integrated with the laser device. The method of manufacturing the above laser device enables commercial manufacture of the laser device in a cost-effective way.

At least one embodiment of the invention will now be described, by way of example only, with reference to the accompanying drawings in which:
**Figure 1** is a schematic diagram of a cross-section of a tunable laser constituting a first embodiment of the invention;
**Figures 2 to 4** are schematic diagrams of stages of fabrication of the tunable laser of Figure 1, constituting a second embodiment of the invention;
**Figures 5 to 8** are schematic diagrams of stages of fabrication of the tunable laser of Figure 1, constituting a third embodiment of the invention; and
**Figures 9(a) to 9(h)** are schematic diagrams of top surfaces of mesas or top surfaces of ridge waveguides for tunable lasers constituting other embodiments of the invention.

Throughout the following description, identical reference numerals will be used to identify like parts.

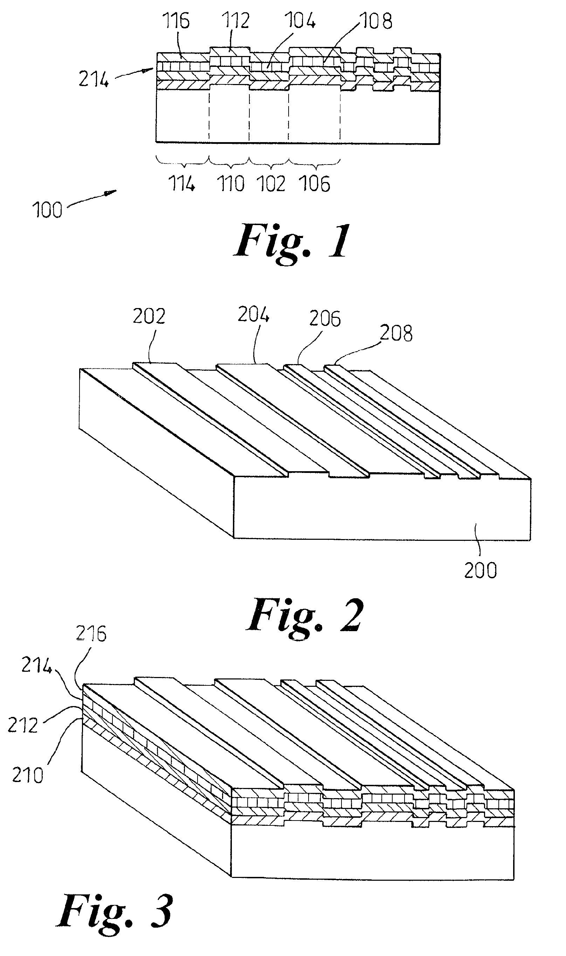

Referring to Figure 1, a tunable laser device 100 comprises a first longitudinal region 102 comprising a first upper waveguide layer region 104, a second longitudinal region 106 comprising a second upper waveguide region 108, a third longitudinal region 110 comprising a third upper waveguide region 112, and a fourth longitudinal portion 114 comprising a fourth upper waveguide region 116. Together, the first, second, third and fourth upper waveguide regions 104, 108, 112, 116 constitute an upper waveguide layer 214.

Referring to Figure 2, the laser device 100 is fabricated by firstly growing a substrate layer 200. Using a known photolighographic process, a first stripe of photoresist (not shown), a second stripe of photoresist (not shown) a third stripe of photoresist (not shown) and a fourth stripe of photoresist (not shown) are formed on the substrate 200 and the substrate 200 is etched to a depth of between about 0.005 µmand 0.5 µm using a known etching technique to form a first raised substrate stripe 202, a second raised substrate stripe 204, a third raised substrate stripe 206 and a fourth raised substrate stripe 208. In common with known laser device fabrication techniques, the following layers are deposited.

A, non-essential, lower waveguide layer 210 (Figure 3) is deposited on the substrate 200 to a depth of between about 0.05 µm and 1 µm. An active layer 212 is then deposited upon the lower waveguide layer 210. In this example, the active layer 212 comprises a plurality of quantum wells (not shown) separated by quantum barriers (also not shown), i.e. a Multi-Quantum Well (MQW) structure. The upper waveguide layer 214 is subsequently deposited upon the active layer 212, and an Indium Phosphide (InP) outer confinement layer 216 (between about 0.1 µm and 1 µm thick) is deposited upon the upper waveguide layer 214.

After deposition of the confining layer 216, photoresist (not shown) is deposited using a stripe mask (also not shown) that is exposed and developed to form a transverse stripe of photoresist (not shown) relative to the first, second, third and fourth substrate stripes 202, 204, 206, 208. The transverse stripe of photoresist is formed in accordance with the above-mentioned known photolithographic technique.

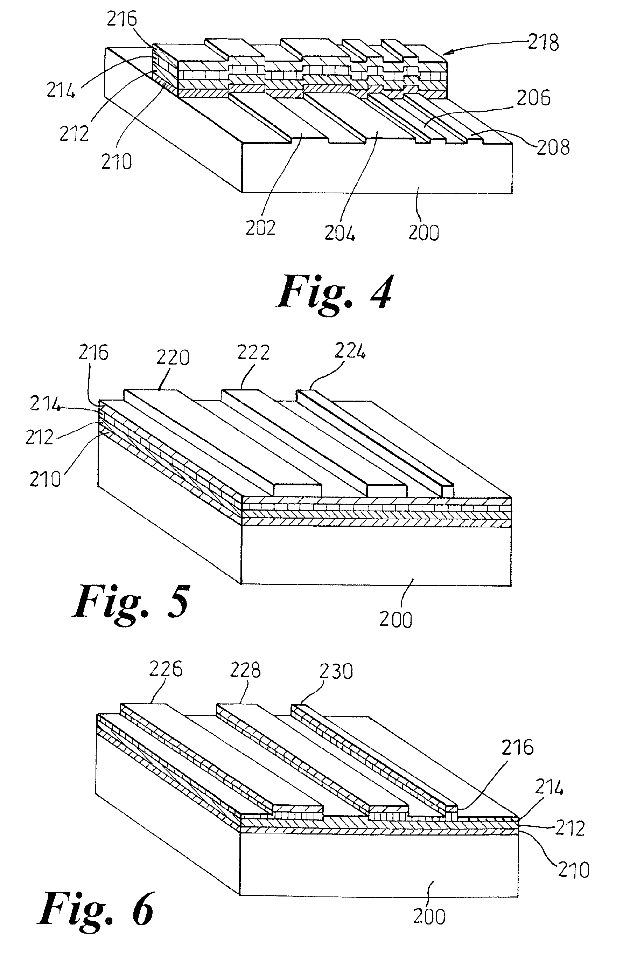

The layers grown above the substrate 200 are then etched down to the substrate 200 using the above-mentioned known etching technique to form a mesa structure 218 (Figure 4). Two InP further confining layers (one p-doped, the other n-doped - not shown) are then overgrown either side of the mesa structure 218. Thereafter, an InP separating layer (not shown) is grown over the device(s) fabricated thus far. A GalnAs cap layer (not shown) is then grown over the InP separating layer and metal contact layers (not shown) are then disposed to n and p sides of the laser device 100. The InP separating layer serves, inter alia, to distance the active layer 212 from the metal contact disposed on the p side of the laser device 100.

In an alternative embodiment (Figures 5 to 8), the substrate 200 is grown and not etched with the first, second, third and fourth substrate stripes 202, 204, 206, 208. The lower waveguide layer 210 is then formed on the substrate 200 and the active layer 212 is formed on the lower waveguide layer 210. The upper waveguide layer 214 is then formed on the active layer 212, the confining layer 216 being formed upon the upper waveguide layer 214.

The first stripe of photoresist 220, the second stripe of photoresist 222 and the third stripe of photoresist 224 are formed on the confining layer 216 using the above-mentioned known photolithographic technique. Where not protected by the first, second and third stripes of photoresist 220, 222, 224, the confining layer 216 is etched away, the etching continuing into the upper waveguide layer 214 to a depth of between about 0.005 µm and the entire thickness of the upper waveguide layer 214. Thereafter, the first, second and third stripes of photoresist 220, 222, 224 are removed to leave a first etched stripe 226, a second etched stripe 228 and a third etched stripe 230.

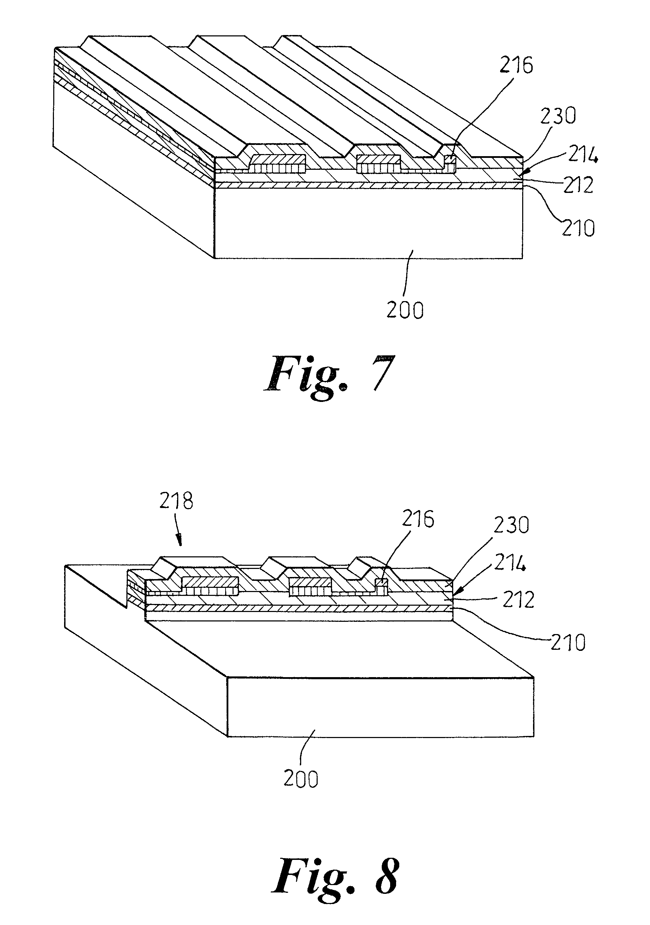

Referring to Figure 7, a further InP confinement layer 232 is then deposited over the above-described grown and etched layers, followed by formation of the transverse stripe of photoresist according to the above-mentioned known photolithographic technique. The layers grown above the substrate 200 are then etched down to, and optionally slightly into, the substrate 200 using the above-mentioned known etching technique to form the mesa structure 218 (Figure 8). Two InP further confining layers (one p-doped, the other n-doped - not shown) are then overgrown either side of the mesa structure 218. Thereafter, an InP separating layer (not shown) is grown over the device(s) fabricated thus far. A GalnAs cap layer (not shown) is then grown over the InP separating layer and metal contact layers (not shown) are then disposed to n and p sides of the laser device 100. The InP separating layer serves, inter alia, to distance the active layer 212 from the metal contact disposed on the p side of the laser device 100.

In the above examples, either the mesa structure 218 formed above the substrate 200 comprises adjacent longitudinal regions of layers vertically displaced from one another (Figure 4), or the upper waveguide layer 214 of the mesa structure 218 comprises adjacent longitudinal regions of differing thicknesses (Figure 8). However, it should be appreciated that other configurations of the upper waveguide layer 214, at least, are possible. For example, referring to Figures 9(a) to (h), the upper waveguide layer 214 spans the first region 102 adjacent, and in contact (or integrally formed) with, a second region 106, the first and second regions 102, 106 defining a continuous surface. The first region 102 comprises a first surface region 232 of the continuous surface, and the second region 106 comprises a second surface region 234 of the continuous side surface. The first surface region 232 meets the second surface region 234, the first surface region 232 being non-coplanar with the second surface region 234. Hence, the upper waveguide layer 214, or another layer of the waveguide region, such as the active layer, comprises a surface that does not substantially lie in a single plane, i.e. the layer in question comprises a step.

It should be appreciated that the configurations of the upper waveguide layer 214 described above in connection with Figures 9(a) to (h) are applicable to all embodiments described herein. It should also be appreciated that the configuration or profile of the upper waveguide layer 214 is such that reflection and scattering of electromagnetic radiation occurs in the upper waveguide layer 214, when the laser device 100 is in use. In this example, the power reflected is between about 0.1% and 10% and the power scattered is between about 0% and 10%. Furthermore, the reflection and scattering is achieved without the provision of damage sites or cleaved gaps in the upper waveguide layer 214.

A first longitudinal position 236 at which the first surface region 232 meets the second surface region 234 is, in the above embodiments, a first fraction of the total longitudinal length of the upper waveguide layer 214. In the above embodiments, for example those of Figures 9(a) to (h), the first region 102 is disposed adjacent the third region 110 in a like manner to the first and second regions 102, 106. A second longitudinal position 238 at which the first surface region 232 meets a third surface region 240 of the continuous surface (corresponding to the third region 110) is a second fraction of the total longitudinal length of the upper waveguide layer 214. The first fraction, in all the above embodiments, is not a multiple, for example 2x, 3x, 4x, ..., nx, or a unit fraction, for example ½, 1/3, ¼, 1/5, ..., 1/n, of the second fraction, although the first fraction can be a multiple or unit fraction of the second fraction.

Referring back to Figure 1, the fourth region 114 can be disposed, as all embodiments described herein, adjacent the third region 110, the disposition of the fourth region 114 adjacent the third region 110 being constrained, with respect to the continuous surface, in a like manner to the first and second regions 102, 106. Again, a third longitudinal position 242 at which the third surface region 240 meets a fourth surface region 244 of the continuous surface 242 (corresponding to the fourth region 114) is a third fraction of the total longitudinal length of the upper waveguide layer 214. The third fraction is not a multiple or unit fraction of other fractions, such as the first, second or third fraction, although it can be. In one example, the first fraction is two-thirds of the total longitudinal length of the upper waveguide layer 214, the second fraction is two-fifths of the total longitudinal length of the upper waveguide layer 214, and the third fraction is one-eighth of the total longitudinal length of the upper waveguide layer 214.

In the above embodiments, the maximum deviation (shortest distance) of the continuous surface of the upper waveguide layer 214 from a narrowest part of the upper waveguide layer 214 to a widest part of the upper waveguide layer 214 is about 0.1µm thereby avoid interference with etching of the mesa structure for buried heterastructure lasers, or for ridge waveguide lasers.

A first pair of contact electrodes are disposed across the first region 102, a second pair of contact electrodes are disposed across the second region 106. Where the third and fourth regions 110, 114 are provided, a third pair of contact electrodes (not shown) and a fourth pair of contact electrodes (not shown) are respectively disposed across the third region 110 and the fourth region 114. The first second, third and fourth pairs of contact electrodes are in respective alignment with the first, second, third and fourth regions 102, 106, 110, 114. However, one or both of each of the first, second, third and fourth pairs of electrodes can encroach upon an adjacent region, for example the first pair of contact electrodes encroaching upon the second region 106 (Figure 1). The encroachment can be up to 10% of the adjacent region. Perceived another way, the second upper waveguide region 108 can extend into the first longitudinal region 102, where the boundaries of the first and second regions 102, 106 are defined by the first and second pairs of contact electrodes, respectively.

In operation, the laser device 100 is tuned by injecting a first current having a first carrier density associated therewith into the first region 102 using the first pair of contact electrodes, and injecting a second current having a second carrier density associated therewith into the second region 106 using the second pair of contact electrodes. If the third region 110 is provided, injection of a third current having a third current density associated therewith into the third region 110 using the third pair of contact electrodes contributes to tuning of the laser device 100. If the fourth region 114 is provided, injection of a fourth current having a fourth current density associated therewith into the fourth region 114 using the fourth pair of contact electrodes contributes to tuning of the laser device 100.

The first and second (and, where applicable, the third and fourth) carrier densities vary independently. The first carrier density results in a first refractive index in the first region 102 corresponding to a first optical length of the first region 102.The second carrier density results in a second refractive index in the second region 106 corresponding to a second optical length of the second region 106. Similarly, the third carrier density results in a third refractive index in the third region 110, and the fourth carrier density results in a fourth refractive index in the fourth region 114 corresponding to a third optical length of the third region 110 and a fourth optical length of the fourth region 114, respectively. The ability to vary the first, second, third and fourth carrier densities combined with the choice of the first, second and third longitudinal positions 236, 238, 242 results in the ability to tune the laser device 100.

By varying the mask used to define the profile of the upper waveguide layer 214, the displacement of the upper waveguide layer 214 in one region relative to an adjacent region can be controlled, thereby achieving selection of reflectivity.

Furthermore, by increasing the width of the upper waveguide layer 214, for example up to 5 µm, in one of the first, second, third or fourth regions 102, 106, 110, 114 a wider range of currents can be injected into the region containing the widened upper waveguide layer before heating effects counteract the changes in refractive index induced by the carrier density. If the width of the upper waveguide layer 214 is in the fourth region 114, i.e. at an end facet of the laser device 100, a wider mode results at the end facet of the laser device adjacent the widened region. Consequently, coupling efficiency of the end facet in question with an optical fibre or an optical component is improved. In order to prevent propagation of first order (or higher) transverse modes, at least a portion of at least one of the longitudinal regions of the laser cavity can be narrower than at least one longitudinal region of the laser cavity adjacent the portion of the at least one of the longitudinal regions of the laser cavity

Although the above embodiments have been described in relation to controlled formation of the upper waveguide layer 214, the formation of the profile of an active layer, for example the MQW layer 212, can alternatively be controlled. Similarly, the formation of profile of the lower waveguide layer 210 can be controlled as a further alternative to control of formation of the profile of the active layer or the upper waveguide layer 214.

It should be appreciated that the above described discontinuities can be formed in non-longitudinal directions substantially parallel with the substrate 200 or in directions perpendicular to the substrate 200.

The laser device 100 of the above embodiment are formed by means of a single sequential growth process, such as Metal Oxide Vapour Phase Epitaxy (MOVPE). However, Liquid Phase Epitaxy (LPE) or Molecular Beam Epitaxy (MBE) techniques are equally applicable.

## Claims

1. A laser device (100) comprising a Fabry-Perot structure including a waveguide region (210, 212, 214), wherein the waveguide region (210, 212, 214) comprises a longitudinal layer having a surface, **characterised in that** the surface of the layer is stepped.

2. A device as claimed in Claim 1, wherein the waveguide region (212, 214, 216) comprises a first sub-region (102) and a second sub-region (106), the first and second sub-regions (102, 106) being substantially independently controllable with respect to each other.

3. A device as claimed in Claim 2, wherein the first sub-region (102) comprises a first waveguide layer (104) and the second sub-region (106) comprises a second waveguide layer (108), the first waveguide layer (104) having a first optical length associated therewith and the second waveguide layer (108) having a second optical length associated therewith, the first and second optical lengths being substantially independently adjustable with respect to each other.

4. A device as claimed in Claim 1, wherein the waveguide region (210, 212, 214) comprises a first sub-region (102) having a first optical length associated therewith and a second sub-region (106) having a second optical length associated therewith, the first and second optical lengths being substantially independently adjustable.

5. A device as claimed in any one of the preceding claims, wherein the waveguide region (210, 212, 214) is arranged to cause reflection, when in use, of electromagnetic radiation generated within the waveguide region (210, 212, 214).

6. A device as claimed in Claim 5, when dependent upon Claim 4, wherein the reflection is caused by the surface being stepped and the first optical length being different to the second optical length.

7. A device as claimed in any one of the preceding claims, wherein the stepped surface comprises a first step located at a first longitudinal position (236) corresponding to a first fraction of a substantially total longitudinal length of the waveguide region (210, 212, 214), and a second step located at a second longitudinal position (238) corresponding to a second fraction of the substantially total longitudinal length of the waveguide region (210, 212, 214), the first fraction not being a multiple or sub-multiple of the second fraction.

8. A tunable laser device as claimed in any one of the preceding claims.

9. A semiconductor laser device as claimed in any one of the preceding claims.

10. A method of manufacturing a laser device, the method comprising the steps of:
constructing a Fabry-Perot laser structure comprising a waveguide region (210, 212, 214), the waveguide region (210, 212, 214) comprising a longitudinal layer having a surface, **characterised by**
forming the longitudinal layer so that the surface is stepped.

11. A method of tuning a laser device (100), the laser device (100) comprising a Fabry-Perot structure including a waveguide region (210, 212, 214), wherein the waveguide region (210, 212, 214) comprises a longitudinal layer having a stepped surface, the waveguide region (210, 212, 214) comprising a first sub-region (102) having a first optical length associated therewith and a second sub-region (106) having a second optical length associated therewith, the method comprising the step of:
independently adjusting the first and second optical lengths so as to cause reflections of electromagnetic radiation within the waveguide region (210, 212, 214).

12. A use of a laser device (100), the laser device (100) comprising a Fabry-Perot structure including a waveguide region (210, 212, 214), the waveguide region (210, 212, 214) comprising a longitudinal layer having a stepped surface, the use being **characterised by** the generation of electromagnetic radiation of a selectable wavelength.
